# EUROPEAN PATENT APPLICATION

(11) **EP 2 230 325 A1**
(43) Date of publication of application: **22.09.2010**
(21) Application number: 09155752.0
(22) Date of filing: 20.03.2009
(51) Int. Cl.: C23C 14/34, C23C 14/35

(54) **Deposition apparatus with high temperature rotatable target and method of operating thereof**

(71) Applicant: Applied Materials, Inc., Santa Clara, CA 95054 (US)
(72) Inventor: Mueller, Joachim, 70736 Fellbach (DE); Trassl, Roland, 35392 Giessen (DE); Liu, Jian, 63538 Grosskrotzenburg (DE)
(74) Representative: Zimmermann & Partner

(57) **Abstract**

A deposition apparatus (100) and a method for sputtering material on a substrate is provided with a substrate holder (110) for holding the substrate, a rotatable target (120) adapted for being sputtered, and a heating system including a back side heating (130) for heating the substrate from the back and a front side heating for heating the substrate from the front. The rotatable target acts as the front side heating and is adapted for heating the substrate to a temperature of at least 100°C.

## Description

### FIELD OF THE INVENTION

The present disclosure generally relates to deposition apparatuses and methods of operating thereof. The present disclosure relates to substrate coating technology solutions involving equipment, processes and materials used in the deposition, patterning, and treatment of substrates and coatings, with representative examples including (but not limited to) applications involving: semiconductor and dielectric materials and devices, silicon-based wafers, flat panel displays (such as TFTs), masks and filters, energy conversion and storage (such as photovoltaic cells, fuel cells, and batteries), solid-state lighting (such as LEDs and OLEDs), magnetic and optical storage, micro-electro-mechanical systems (MEMS) and nano-electro-mechanical systems (NEMS), micro-optic and opto-elecro-mechanical systems (NEMS), micro-optic and optoelectronic devices, transparent substrates, architectural and automotive glasses, metallization systems for metal and polymer foils and packaging, and micro- and nano-molding. More specifically, it relates to sputter apparatuses having a rotatable target and methods of operating thereof.

### BACKGROUND OF THE INVENTION

In many applications, it is necessary to deposit thin layers on a substrate. The term "substrate" as used herein shall embrace both inflexible substrates, e.g. a wafer or a glass plate, and flexible substrates such as webs and foils. Known techniques for depositing layers are in particular evaporating and sputtering.

In an evaporation process, the material to be deposited is heated so that it evaporates and condenses on the substrate. Sputtering is a vacuum coating process used to deposit thin films of various materials onto the surface of a substrate. For example, sputtering can be used to deposit a metal layer such as a thin layer of aluminium or ceramics. During the sputtering process, the coating material is transported from a target consisting of that material to the substrate to be coated by bombarding the surface of the target with ions of an inert gas that are accelerated by a high voltage. When the gas ions hit the outer surface of the target, their momentum is transferred to the atoms of the material so that some of them can gain sufficient energy to overcome their bonding energy in order to escape from the target surface and to deposit on the substrate. Thereon, they form a film of the desired material. The thickness of the deposited film is, inter alia, dependent on the duration of exposing the substrate to the sputtering process.

For example, sputtering is used in the production of thin-film solar cells. Generally, a thin-film solar cell comprises a back contact, an absorbing layer, and a transparent and conductive oxide layer (TCO). Typically, the back contact and the TCO layer is produced by sputtering whereas the absorbing layer is typically made in a chemical vapour deposition process. In comparison to an evaporation process such as chemical vapour deposition, sputtering is advantageous in that also materials can be sputtered that cannot be evaporated. Further, the adhesion of the produced layers to the substrate is typically stronger in sputtering processes than in evaporation processes. Further, sputtering is a directional process so that the major part of the material is transferred to the substrate and does therefore not coat the interior of the deposition apparatus (as in evaporation applications).

Notwithstanding the advantages of sputtering, sputtering has also drawbacks. In comparison to evaporation, sputtering a substrate takes longer. Sputtering rates are normally much lower than evaporation rates. It is therefore an ongoing desire to speed up sputtering processes.

On the other hand, despite the better adhesion of sputtered layers to the substrate, it is an ongoing desire to further improve the quality of the deposited layers.

### SUMMARY OF THE INVENTION

In view of the above, a deposition apparatus and a method for depositing a layer on a substrate are provided.

According to one aspect, a deposition apparatus for sputtering material on a substrate is provided with a substrate holder for holding the substrate, a rotatable target adapted for being sputtered, and a heating system including a back side heating for heating the substrate from the back and a front side heating for heating the substrate from the front. The rotatable target acts as the front side heating and is adapted for heating the substrate to a temperature of at least 100°C.

According to another aspect, a method for depositing a layer of depositing material on a substrate in a deposition apparatus is provided, the method including holding a substrate, rotating a rotatable target, sputtering material on the substrate, heating the substrate to a temperature of at least 100°C by the front side heating, and using the rotatable target for heating the substrate from the front.

The description that the front side heating is adapted for heating the substrate to a temperature of 100°C has to be understood in that the front side heating is adapted for causing a temperature rise of the substrate up to a temperature of 100°C.

According to a further aspect, a deposition apparatus for sputtering material on a substrate is provided with a substrate holder for holding the substrate, a rotatable target adapted for being sputtered, and a heating system including a back side heating for heating the substrate from the back and a front side heating for heating the substrate from the front. The rotatable target acts as the front side heating and is adapted for increasing the substrate's temperature by an increment of at least 100°C.

According to another aspect, a method for depositing a layer of depositing material on a substrate in a deposition apparatus is provided, the method including holding a substrate, rotating a rotatable target, sputtering material on the substrate, increasing the substrate's temperature by an increment of at least 100°C by the front side heating, and using the rotatable target for heating the substrate from the front.

According to embodiments, the front side heating is adapted for heating the substrate to a temperature of at least 200°C, more typically to a temperature of at least 300°C. According to embodiments, the front side heating is adapted for increasing the substrate's temperature by an increment of at least 200°C, more typically at least 300°C.

Further aspects, details, advantage and features are apparent from the dependent claims, the description and the accompanying drawings.

Embodiments are also directed to apparatuses for carrying out each of the disclosed methods and including apparatus parts for performing each described method steps. These method steps may be performed by way of hardware components, a computer program by appropriate software, by any combination of the two or in any other manner. Furthermore, embodiments are also directed to methods by which the described apparatus operates or by which the described apparatus is manufactured. It includes method steps for carrying out functions of this apparatus or manufacturing parts of the apparatus.

### BRIEF DESCRIPTION OF THE DRAWINGS

Some of the above indicated in other more detailed aspects of the invention will be described in the following description and partially illustrated with reference to the figures. Therein:
Fig. 1 is a schematic cross sectional view of a deposition apparatus according to embodiments described herein;
Fig. 2 is a schematic cross sectional view of a rotatable target according to embodiments described herein;
Fig. 3 is a schematic cross sectional view of a rotatable target according to embodiments described herein;
Fig. 4 is a schematic cross sectional view of a deposition apparatus according to embodiments described herein;
Fig. 5 is a schematic time-temperature diagram describing a deposition process;
Fig. 6 is a schematic time-temperature diagram describing another deposition process;
Fig. 7 is a schematic time-temperature diagram describing another deposition process;
Fig. 8 is a temperature-mass density diagram describing the dependence of the layer density on the deposition temperature;
Fig. 9 is a schematic cross-sectional view of a rotatable target according to embodiments described herein; and
Fig. 10 is a schematic cross-sectional view of a rotatable target according to embodiments described herein.

### DETAILED DESCRIPTION OF THE DRAWINGS

Within the following description of the drawings, the same reference numbers refer to the same components. Generally, only the differences with respect to the individual embodiments are described.

The process of coating a substrate with a material as described herein refers typically to thin-film applications. The term "coating" and the term "depositing" are used synonymously herein.

The deposition apparatus comprises a process source. Generally, this is a rotatable target adapted for being sputtered. As will be discussed in more detail below, the rotatable target can be a bonded rotatable target or a non-bonded rotatable target.

Generally, sputtering can be undertaken as diode sputtering or magnetron sputtering. The magnetron sputtering is particularly advantageous in that its deposition rates are rather high. Typically, a magnet is positioned within the rotatable target. By arranging the magnet or the magnets behind the target, i.e. inside of the target in the event of a rotatable target, in order to trap the free electrons within the generated magnetic field directly below the target surface, these electrons are forced to move within the magnetic field and cannot escape. This enhances the probability of ionizing the gas molecules typically by several orders of magnitude. This, in turn, increases the deposition rate magnificently.

When using the target as a front side heating for the substrate, it is typical that the temperature of the target is controlled such that it is limited by the melting temperature of the target material. Further, in the event of a two- or more piece target, such as in the event of a target tube and a target backing tube, it has to be limited in order to take the different thermal expansion coefficients of the backing tube and the target into account. In other words, the heating has to be undertaken such that the more piece target does not crack due to the heating. Further, the further condition has typically to be considered that the magnets are not allowed to exceed a certain temperature.

According to some embodiments, the front side heating is undertaken by a multitude of rotatable targets. That is, the deposition apparatus comprises at least two rotatable targets. The multitude of targets acts as front side heating of the substrate. Further, according to some embodiments, the heat profile of the substrate can be provided in several steps. For instance, one of the multitude of rotatable targets is heated to a lower temperature than the other one.

Typically, the magnets used within the rotatable target are permanent magnets. The permanent magnets typically need cooling because they are positioned within the target tube which is, according to an aspect, held at a high temperature. In operation, the magnets become rather hot. This is due to the fact that they are surrounded by the rotatable target that is bombarded with ions. Due to the resulting collisions this leads to a heating up of the target.

For that reason, it is usual to provide a cooling of the target and the magnets. This was done in order to keep the magnets at a suitable operating temperature. Further, it has been generally assumed that the optimum deposition temperature is below a certain temperature

Surprisingly, it has been found by the inventors that high temperatures of the target increase the quality of the deposited substrate when compared with the same application at lower temperatures. When talking about quality within the present disclosure, this is to be understood as, for example, the resistivity (which shall be, depending on the application, have a specific value that can be high or low), the optical parameters such as the absorption spectrum, the thickness, the density, the hardness, the adhesion, the scratch resistance, etc. Depending on the specific application, one or more of these properties of the coated layer have to be set to a desired value. Moreover, this value should vary neither within the same layer nor between several coated substrates.

When examining the effect of the higher target temperature, it has further been found that the process of bombarding the material away from the target, i.e. the sputtering in a strict sense, is not very much influenced by the higher temperature. That is, the sputtering process step of solving the material from the target was not found to be influenced by the temperature. Further research revealed that it is the effect of the high temperature target on the substrate that leads to an improved layer deposition. Hence, according to aspects of the present disclosure, it is advantageous to provide a heating from the front side of the substrate in order to heat the substrate up and to provide a heating from the front side as well. In order to do the latter, the rotatable target is used as front side heating.

However, in particular in view of magnetron sputtering, it has to be considered that the magnets must be kept at an operating temperature below a certain threshold value. The typical threshold value for magnet operation is about 80°C. In order to allow the target to become hotter than the threshold temperature of the magnets, it is possible to provide for heat isolation between the outer target and the inside of the target. Such an isolation may be the target material itself (if it is heat isolating). It is also possible to have an additional layer between outer target that is supposed to be sputtered and the target tube carrying the outer target. For instance, the additional layer may also be a bonding layer for bonding the target material to the target tube.

In addition to the front side heating performed by the target, a back side heating is provided that heats the substrate from the back side. By this combined heating system it can be assured that the substrate is held at a high temperature. According to aspects, the front side heating causes the substrate to a temperature of at least 100 degree Celsius. It has been found that the quality of the layers deposited at such a temperature is when compared to layers deposited at lower temperatures. This effect is further enhanced when the temperature rise caused by the front side heating is to a temperature of at least 200°C, 300°C or even at least 400°C. Generally, there is no clear-cut correlation between the temperature of the target and the substrate temperature. There might be embodiments where the target is heated to a high temperature such as up to 400°C and, nonetheless, the substrate is somewhat in the range of the ambient temperature. Hence, according to the present disclosure, it has to be assured that the substrate is at least 100°C or even hotter by the effect of the target acting as front side heating.

The present disclosure is directed to the coating of several materials. In particular, it is related to the coating of glass. Glass plates have normally a rather high heat storage capacity so that, once they are heated, e.g. prior to entering the deposition chamber, the temperature drop is moderate. Nonetheless, by providing the front side heating, the whole production process becomes more cost-effective because the preheating can be reduced. Moreover, the positive effects of the additional front side heating become effective at lower temperatures if compared to wafer coating. In particular, when coating glass, it is typical that the temperature rise caused by the front side heating is at least 150°C or 200°C.

The present disclosure is also typically related to wafer coating. The heat storage capacity of the wafers is typically low. Hence, in prior art, if they are preheated prior to entering the deposition chamber, their temperature drop within the deposition chamber is considerable. Hence, by the application of the present disclosure, in particular by providing a front side heating capable of heating the wafer to a temperature of at least 100°C, the temperature within the chamber can be held at a high chamber.

It is typical to heat wafers to high temperatures. Typically, the front side heating heats the wafer to a temperature of at least 250°C, 300°C or even 400°C. In many embodiments of coating wafers, higher temperatures such as between 350°C and 500°C or even 550°C, cause particularly noticeable the positive effects of a quality increase. For instance, this may occur for coating a silicon nitride layer on a wafer.

Typically, the thickness of the deposited layer is smaller than 1 mm, more typically smaller 1 µm, even more typically smaller than 100 nm.

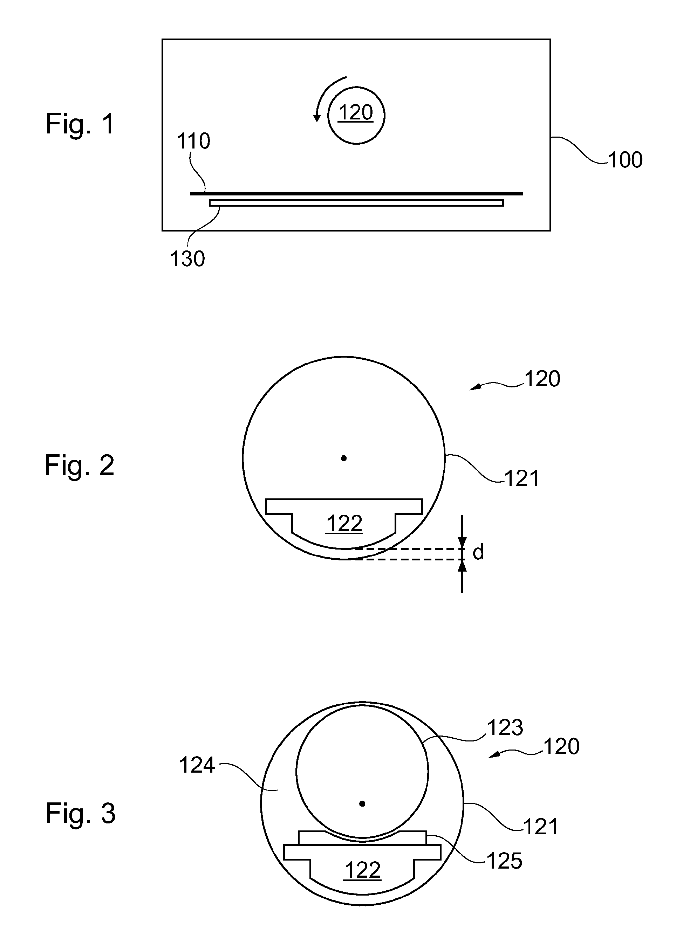

Fig. 1 shows schematically a cross-section of an embodiment of a deposition apparatus as described herein. The deposition apparatus 100 comprises a substrate holder 110 for holding the substrate that is to be coated. It further comprises a rotatable target 120 that is adapted for being sputtered. The arrow depicted in Fig. 1 shall emphasize that - in operation - the target is continuously rotated. The rotatable target acts as a front side heating of the substrate. In addition, the substrate is heated from the back side, too. In order to do so, a back side heating 130 is provided.

Typically, the rotatable target comprises a target tube. The target tube is denoted by reference number 121 in Fig. 2. In addition, according to embodiments described herein, the rotatable target comprises a magnetic device. In Fig. 2, the magnetic device is denoted by reference number 122. Typically, the magnetic device is positioned on the lower side within the target. In this case, a so-called sputter-down is performed where the target is positioned above the substrate. In so-called sputter-up processes, the target is positioned below the substrate. In this case, the magnetic device is positioned on the upper side of the target.

In more general terms, the magnetic device is positioned on that side of the target that is closer to the substrate to be coated. The rotatable target is typically of cylindrical shape. According to many embodiments, at least a part of the surface of the magnetic device is - in its cross section - circularly shaped. This is also exemplarily shown in Fig. 2 and 3 where the lower surface part of the magnetic device runs collaterally to the shape of the rotatable tube.

In Fig. 2, the distance d between the collaterally running part of the surface of the magnetic device 122 and the tube 121 can be seen. According to typical embodiments, the distance is smaller than 5 mm, more typically smaller than 3 mm and even more typically smaller than 2 mm. By having a small distance, the magnetic effect of the magnetic device can be fully exploited. In addition, it prevents that the cooling medium flowing in the thin interspace between target tube and magnetic device around the magnetic device effectively cools down the target tube. This is due to the fact that the rotatable target has a high operating temperature (for more details see below) whereas the magnetic device's temperature is limited by the operating threshold temperature above which the magnets do not work anymore.

As described herein, it is desired to heat the target up to a high temperature. Typically, at the same time, it is desired to keep the magnetic device below the operation threshold temperature. By reducing the space between the magnetic device and the target, the cooling of this region of the target tube is not effective due to the small interspace through which the flow has to take place. Hence, the target is insignificantly cooled. This effect can be further enhanced by providing the tube with isolating material which will be discussed in more detail below.

Fig. 3 shows another embodiment of the rotatable target. In addition to the elements shown in Fig. 2, Fig. 3 comprises the inner tube 123. Typically, the inner tube is adapted for holding the magnetic device. Both the inner tube and the magnetic device are static whereas the target tube typically is adapted to rotate. According to some embodiments, the inner tube cooperates with an interface. In Fig. 3, the interface is denoted with reference number 125. Typically, the interface is linked to the inner tube on its upper side and is linked to the magnet device on its lower side. The inner tube is filled with air in many embodiments. The remaining volume between inner tube and target tube can be filled with a cooling medium in order to cool the magnetic device. This volume is denoted by reference number 124 in Fig. 3. The choice of the cooling medium depends on the temperatures within the tube. Typically, oil or water is used for cooling. Typical temperatures within the target tube are between 40°C and 80°C.

Filling the target tube with a cooling medium provides a cooling system that is arranged within the rotatable target. The cooling system serves the cooling of the interior of the target. Most of all, this is the magnetic device. The cooling system according to embodiments described herein has to be adapted for keeping the magnetic device at a temperature of less than the magnetic device operating threshold temperature. On the other hand, it has to be adapted for cooling the rotatable target as less as necessary so that the rotatable target can still act as a front side heating for the substrate. According to typical embodiments, a control feedback loop is provided that controls the cooling element of the rotatable target. Typically, the control feedback loop comprises a substrate temperature measurement and control means like a metering valve for the supply of cooling fluid. Alternatively or in addition to the temperature measurement of the target, a substrate temperature measurement can be provided. For instance, it is possible that the substrate temperature is constantly controlled to be at or larger than the predetermined minimum temperature. Depending on the temperature measurement result, the cooling fluid temperature is adjusted accordingly, i.e. increased, if the substrate tends to be too cold, or decreased, if the substrate temperature tends to be too high. Typically, water is used as cooling fluid.

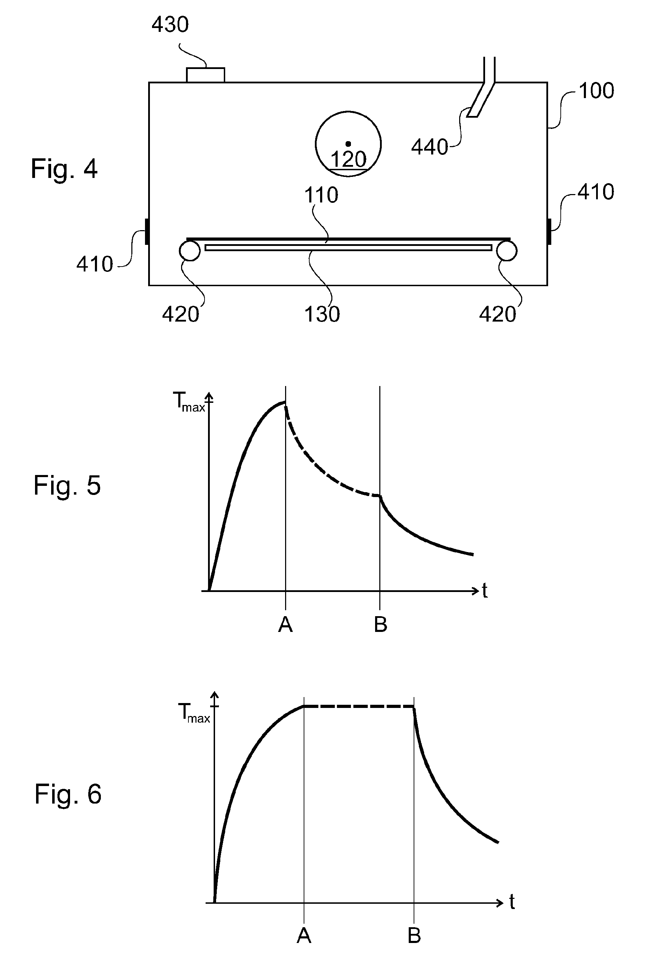

Fig. 4 shows schematically an embodiment of a deposition apparatus as described herein. In comparison to the features already shown with respect to the embodiment of Fig. 1, the embodiment of Fig. 4 further comprises slits 410. The slits serve to let enter a substrate into the deposition apparatus and to forward it out of the deposition apparatus after being coated. The embodiment further shows transporting portions 420 such as rolls that are adapted for moving the substrate holder 110, e.g. to the right of the deposition apparatus for receiving a new substrate through slit 410.

Further, the deposition apparatus comprises an outlet 430 for being connected with a vacuum pump. In other embodiments, reference number 430 refers to at least one vacuum pump that is arranged directly on the deposition apparatus. Further, the apparatus comprises an inlet 440 for the sputtering gas. Typically, the sputtering gas is an inert gas that is introduced into the deposition apparatus when in operation. According to a typical embodiment, the sputtering gas is Argon. The sputtering gas is ionized by the electrons and afterwards accelerated towards the target in order to solve the target material from the target. The typically atmosphere within the deposition apparatus is between 10⁻² mbar and 10⁻⁴ mbar.

The gas introduced into the deposition apparatus may further comprise an element that binds to the target material. For instance, the production of a silicon nitride layer may be done by providing bulk silicon as target, and by introducing nitrogen gas into the apparatus. Further, in the event that a hydrogen-containing silicon nitride layer is desired, small amounts of ammonia (NH₃) or hydrogen (H₂) gas are added apart from the nitrogen gas. This benefits the layer quality in terms of passivation properties.

Fig. 5 is a schematic diagram showing the temperature of a substrate to be coated in dependence on the time. The figures 5 to 7 have to be compared in order to understand the advantages of the embodiments described herein.

Fig. 5 describes the time temperature dependence in a deposition process in the art. Therein, the substrate to be coated is heated to a high temperature which is called Tₘₐₓ herein. Typically, the substrate is heated from both sides prior to entering the deposition apparatus so that it has the temperature Tₘₐₓ when entering the deposition apparatus or the processing zone. At time A, the substrate enters the deposition apparatus and the temperature decreases massively because there is no front side heating within the deposition apparatus. Hence, between the times A and B the substrate is coated at a decreasing temperature that becomes very quickly much below the temperature Tₘₐₓ. Typically, this temperature (e.g. at time B) is about 300 degree Celsius. Once the substrate is coated, it is taken from the deposition apparatus for cooling down. This is shown in the diagram after time B. The massive decrease of the temperature right after time A is due to the fact that there is no front side heating within the deposition apparatus, but maybe only a back side heating. Hence, the overall heating capacity within the deposition apparatus is not large enough in order to keep the substrate at a high temperature.

Fig. 6 shows the time-temperature relation of a deposition process according to embodiments described herein. Typically, the temperature trend as shown is measured at a wafer as substrate. As described previously, according to some embodiments, the substrate is heated to a preheating temperature Tₘₐₓ prior to entering the deposition apparatus. According to typical embodiments, the temperature Tₘₐₓ is in the range of at least 300°C, more typically at least 400°, even more typically 450°C or even 500°C. According to the present disclosure, however, it is possible to reduce the preheating in comparison to conventional preheating since there is no large temperature decrease to be expected within the deposition apparatus. Hence, according to some embodiments, the preheating temperature Tₘₐₓ is maximally 500°C, more typically maximally 450°, even more typically maximally 400°C. By reducing the preheating power the overall power consumption can be reduced leading to a cheaper production of the coating. In other embodiments, in particular if the sputtered material is a TCO, the preheating temperature is maximally 400°C, more typically maximally 350°C, or even more typically maximally 300°C.

The substrate is then fed to the deposition apparatus that comprises a heating system with a back side heating for heating the back side of the substrate, and a front side heating for heating the front side of the substrate. Therefore, it is possible to keep the temperature of the substrate at a high level. According to the embodiment shown in Fig. 6, the temperature is held at the temperature Tₘₐₓ.

As described with respect to Fig. 5, the substrate is coated during time A and B. Thereby, according to embodiments described herein, at least one of the following effects can be capitalized on: Firstly, the temperature decrease during the coating process is small in comparison to the absolute value of the temperature. For instance, the decrease can be smaller than 20% of Tₘₐₓ or even smaller than 10%. According to some embodiments, it is kept constant at this temperature wherein "constant" in this context typically refers to a maximum deviation of 5%.

Secondly, the absolute temperature of the substrate is at a high level. According to an aspect, the temperature is at least 100 degree Celsius. According to yet another embodiment, the substrate temperature is kept at at least 200 degree Celsius, more typically at at least 300 degree or even 400 degree Celsius. The high temperature of the substrate improves the layer quality.

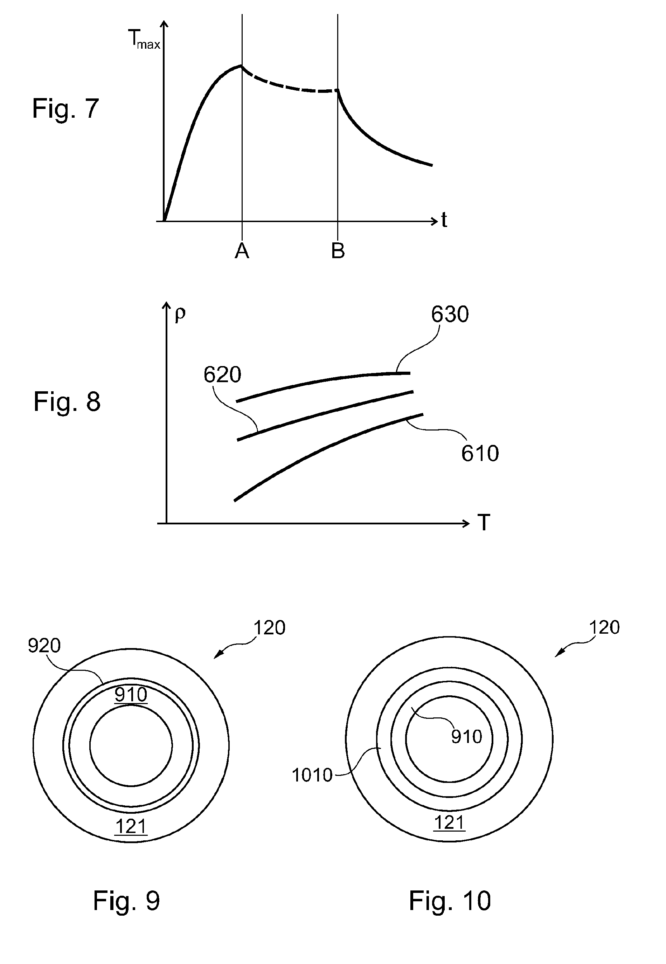

Fig. 7 shows another deposition embodiment as described herein. As in the embodiment of Fig. 6, the heating system arranged within the deposition apparatus is adapted for keeping the substrate at a high temperature. However, in contrast to the embodiment exemplarily explained with respect to Fig. 6, this temperature is smaller than the original preheating temperature Tₘₐₓ. Hence, once the substrate is entered into the deposition apparatus at time A, the substrate temperature decreases slightly as it is shown in Fig. 7. In some examples, the decrease is maximally up to 15%, typically maximally up to 10% or even 5% of the temperature Tₘₐₓ. In any event, the decrease has to fulfil the condition that the substrate temperature is still at least 100 degree Celsius during the deposition process so that the layer quality will ameliorate in comparison to deposition techniques in the art. In typical embodiments, the substrate temperature is still at least 200°C, 300°C or even 400°C.

Fig. 8 is a diagram on the temperature dependence of the mass density of the deposited substrates. It was measured for silicon nitride (SiN) layers and refers to values in the order of magnitude of some g/cm³. The temperature has been varied between 0 and 400 degree Celsius. The three schematically drawn result graphs relate to sputtering processes at different pressures. In more detail, the line 610 refers to a high pressure with the pressure being the range of 10 µbar, the line 620 refers to a pressure of about 4 µbar, and the line 630 refers to a pressure of about 2 µbar.

As can be seen from these research results, the mass density p increases at higher substrate temperatures. Along with the substrate mass density p, the overall layer quality improves as well.

Fig. 9 shows a schematic cross sectional view of a rotatable target according to embodiments. It shows a cylindrical target tube 121.

Generally, all metals and ceramics having a sufficient conductivity can be sputtered. Depending on the reactive gases, dielectric layers can also be formed. The layers deposited are typically amorphous or monocrystalline. Typically, for metallic processes or dielectric layers from ceramic targets, DC power is used for sputtering. In the event of reactive processes, MF power is normally used.

In general, the target tube is typically made of a metal. Typical materials used for sputtering are silicon (Si), indium (In), indium alloys such as indium tin (InSn), tin (Sn), zinc (Zn), aluminium (Al), silicon nitride (SiN), copper (Cu), aluminium oxide (Al₂O₃), zinc oxide (ZnO), CuInGa (CIG), or combinations thereof such as ZnO:Al₂O₃. Typically, the deposited layer such as the silicon layer is a crystalline layer. Generally, all metals and ceramics that are conducting enough can be sputtered. Depending on the reactive gas, dielectric layers can be formed such as e.g. hydrogen-containing silicon nitride (SiN:H). The layers are typically amorphous or microcrystalline.

According to some embodiments, the target tube is bonded to a target backing tube that is denoted by reference number 910 in the embodiment of Fig. 9. The bonding layer is denoted by reference number 920 in Fig. 9. Typically, the bonding material is indium based.

According to some embodiments, a material having a small thermal conductivity is chosen as bonding material. The bonding material can thus be a thermal insulator, typically having a thermal conductivity of smaller than 0.3 W/mK, more typically smaller than 0.2 W/mK or even smaller than 0.1 W/mK.

According to other embodiments, a non-bonded rotatable target is used for sputtering. In this event, for example, the target tube is either connected in a non-bonded way to a target backing tube such as by mechanical pressure, or the rotatable target is a one-piece tube consisting of the material to be coated only.

According to the embodiments that shall exemplarily be illustrated with respect to Fig. 10, an additional layer is positioned between the target tube 121 and the target backing tube 910. This layer is denoted by reference number 1010 in Fig. 10. For instance, this layer can be made of a thermally isolating material. Typically, the thermal conductivity of the additional layer is smaller than 0.3 W/mK, more typically smaller than 0.2 W/mK or even smaller than 0.1 W/mK.

It is further possible that this layer does not completely fill the area between the target backing tube and the target tube. For instance, it can be designed as spacers that are arranged at least at some positions between the target tube and the target backing tube such as at three or four positions. Since the target tube is located in the deposition apparatus vacuum, and therefore the vacuum is present also in between the target backing tube and the target tube, this embodiment will also provide for a good thermal isolation.

Due to the fact that the rotatable target is kept at a high temperature, the deposition apparatus and the environment of it become very hot according to an aspect described herein. Therefore, according to some embodiments, the deposition apparatus is provided with an exterior cooling system. According to some embodiments, the exterior cooling system (not shown in the figures) is attached to the deposition apparatus, for example above the position of the target. The exterior cooling system prevents the deposition apparatus from an overall heating.

The application of present disclosure allows maintaining the substrate temperature at a high level during coating. This is particularly useful for coating thin layers such as silicon wafers. Further, it allows reducing the preheating power and is thus more cost effective. This is particularly useful in coating applications where glass or the like is coated which has a high specific heat capacity.

While the foregoing is directed to embodiments of the invention, other and further embodiments of the invention may be devised without departing from the basic scope thereof, and the scope thereof is determined by the claims that follow.

This written description uses examples to disclose the invention, including the best mode, and also to enable any person skilled in the art to make and use the invention. While the invention has been described in terms of various specific embodiments, those skilled in the art will recognize that the invention can be practiced with modification within the spirit and scope of the claims. Especially, mutually non-exclusive features of the embodiments described above may be combined with each other. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims.

## Claims

1. A deposition apparatus (100) for sputtering material on a substrate, the deposition apparatus comprising:
- a substrate holder (110) for holding the substrate;
- a rotatable target (120) adapted for being sputtered;
- a heating system having
- a back side heating (130) for heating the substrate from the back; and
- a front side heating for heating the substrate from the front;
wherein the rotatable target acts as the front side heating; and
wherein the front side heating is adapted for heating the substrate to a temperature of at least 100°C.

2. The deposition apparatus according to any of the preceding claims, the rotatable target comprising a target tube (121) and a magnetic device (122).

3. The deposition apparatus according to any of the preceding claims, the deposition apparatus further comprising a cooling system (124) arranged within the rotatable target for cooling the interior of the target.

4. The deposition apparatus according to claim 3, wherein the cooling system is adapted for keeping the magnetic device at a temperature of less than 80°C.

5. The deposition apparatus according to claim 4 or 5, further comprising a control feedback loop for controlling the cooling system (124) of the rotatable target.

6. The deposition apparatus according to any of the preceding claims, the heating system further comprising an exterior heating system that is arranged in front of the deposition apparatus.

7. The deposition apparatus according to any of the preceding claims, the deposition apparatus further having a cooling system arranged attached to the deposition apparatus.

8. The deposition apparatus according to any of the preceding claims, adapted for depositing a layer on a wafer.

9. The deposition apparatus according to any of the preceding claims, further comprising at least one further rotatable targets, the rotatable target and the at least one further rotatable target acting as front side heating.

10. A method for depositing a layer of depositing material on a substrate in a deposition apparatus, the method comprising:
- holding a substrate;
- rotating a rotatable target;
- sputtering material on the substrate;
- heating the substrate to a temperature of at least 100°C by heating the substrate from the front side; and
- using the rotatable target for heating the substrate from the front.

11. The method for depositing a layer on a substrate according to claim 10, further cooling the interior of the target.

12. The method for depositing a layer on a substrate according to any of the preceding claims 10-11, further comprising
- operating a magnetic device positioned within the rotatable target;
- keeping the magnetic device at a temperature of less than 80°C.

13. The method for depositing a layer on a substrate according to any of the preceding claims 10-12, further heating the substrate prior to feeding the substrate to the deposition apparatus.

14. The method for depositing a layer on a substrate according to any of the preceding claims 10-13, further comprising the step of cooling the deposition apparatus.

15. The method for depositing a layer on a substrate according to any of the preceding claims 10-14, wherein the substrate held is a wafer.

## Amended claims

### Amended claims in accordance with Rule 137(2) EPC.

**1.** A deposition apparatus (100) for sputtering material on a substrate, the deposition apparatus comprising:
- a substrate holder (110) for holding the substrate;
- a rotatable target (120) adapted for being sputtered, the rotatable target comprising a target tube (121) and a magnetic device (122);
- a heating system having
- a back side heating (130) for heating the substrate from the back; and
- a front side heating for heating the substrate from the front;
wherein the rotatable target acts as the front side heating; and
wherein the front side heating is adapted for heating the substrate to a temperature of at least 100°C.

**2.** The deposition apparatus according to any of the preceding claims, the deposition apparatus further comprising a cooling system (124) arranged within the rotatable target for cooling the interior of the target.

**3.** The deposition apparatus according to claim 2, wherein the cooling system is adapted for keeping the magnetic device at a temperature of less than 80°C.

**4.** The deposition apparatus according to claim 4 or 3, further comprising a control feedback loop for controlling the cooling system (124) of the rotatable target.

**5.** The deposition apparatus according to any of the preceding claims, the heating system further comprising an exterior heating system that is arranged in front of the deposition apparatus.

**6.** The deposition apparatus according to any of the preceding claims, the deposition apparatus further having a cooling system arranged attached to the deposition apparatus.

**7.** The deposition apparatus according to any of the preceding claims, adapted for depositing a layer on a wafer.

**8.** The deposition apparatus according to any of the preceding claims, further comprising at least one further rotatable targets, the rotatable target and the at least one further rotatable target acting as front side heating.

**9.** A method for depositing a layer of depositing material on a substrate in a deposition apparatus, the method comprising:
- holding a substrate;
- rotating a rotatable target;
- sputtering material on the substrate;
- heating the substrate to a temperature of at least 100°C by heating the substrate from the front side; and
- using the rotatable target for heating the substrate from the front.

**10.** The method for depositing a layer on a substrate according to claim 10, further cooling the interior of the target.

**11.** The method for depositing a layer on a substrate according to any of the preceding claims 10-11, further comprising
- operating a magnetic device positioned within the rotatable target;
- keeping the magnetic device at a temperature of less than 80°C.

**12.** The method for depositing a layer on a substrate according to any of the preceding claims 10-12, further heating the substrate prior to feeding the substrate to the deposition apparatus.

**13.** The method for depositing a layer on a substrate according to any of the preceding claims 10-13, further comprising the step of cooling the deposition apparatus.

**14.** The method for depositing a layer on a substrate according to any of the preceding claims 10-14, wherein the substrate held is a wafer.
